# EUROPEAN PATENT APPLICATION

(11) **EP 2 383 724 A1**
(43) Date of publication of application: **02.11.2011**
(21) Application number: 11174745.7
(22) Date of filing: 23.08.2005
(51) Int. Cl.: G09G 3/34, G02B 26/00, G02B 26/02

(54) **Apparatus and method for actuating display elements**

(30) Priority: 27.08.2004 US 604896 P; 31.08.2004 US 606223 P; 25.02.2005 US 159073
(62) Divisional of application: 05790203.3
(71) Applicant: Qualcomm Mems Technologies, Inc., San Diego, CA 92121 (US)
(72) Inventor: CUMMINGS, William J., Millbrae, California 94030 (US)
(74) Representative: Dunlop, Hugh Christopher

(57) **Abstract**

An apparatus and method for updating a display comprising means (12a, 12b) for modulating light, such as interferometric modulators. First and second potential differences having opposite polarity and an approximately equal magnitude sufficient are applied to actuate the modulating means (12a, 12b). The potential differences are applied to the modulating means (12a, 12b) at defined times and for defined time durations that depend on a rate at which image data is written to modulating means (12a, 12b), and are applied for an approximately equal amount of time over a given period of display use.

## Description

Microelectromechanical systems (MEMS) include micro mechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by an air gap. Such devices have a wide range of applications, and it would be beneficial in the art to utilize and/or modify the characteristics of these types of devices so that their features can be exploited in improving existing products and creating new products that have not yet been developed.

### SUMMARY

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Preferred Embodiments" one will understand how the features of this invention provide advantages over other display devices.

In one embodiment, the invention provides an apparatus comprising a controller configured to control a driver circtuit that actuates a MEMS display element with a potential difference of a first polarity during a first portion of a display write process. The controller is configured to cause the driver circuit to release the MEMS display element after said actuation and then to actuate the MEMS display element with a potential difference of a polarity opposite to the first polarity during a second portion of said display write process. The apparatus further comprises at least one output port configured to communicate at least in part the potential difference to the MEMS display element during the first portion of the display write process.

In another embodiment, the invention provides an apparatus configured to drive a set of MEMS display elements. The apparatus comprises means for controlling actuation of the MEMS display elements with a potential difference of a first polarity during a first portion of a display write process. The apparatus further comprises means for causing release of the MEMS display elements and means for controlling actuation of the MEMS display elements with a potential difference having a polarity opposite the first polarity during a second portion of the display write process. The apparatus futher comprises means for communicating at least in part the potential differences to the MEMS display element during the first portion of the display write process.

In still another embodiment, the invention provides a method of actuating a set of MEMS display elements, said MEMS display elements comprising a portion of an array of MEMS display elements. The method comprises actuating said MEMS display elements with a potential difference of a first polarity during a first portion of a display write process, releasing said MEMS display elements and then actuating said MEMS display elements with a potential difference having a polarity opposite said first polarity during a second portion of said display write process.

In yet another embodiment, the invention provides an apparatus configured to operate a MEMS display element in an array of MEMS display elements. The apparatus comprises a controller confígured to control a driver circuit that periodically applies a first and second potential difference to the MEMS element. These first and second potential differences have opposite polarities and approximately equal magnitudes which are sufficient to actuate the MEMS element. The controller is configured to periodically apply theses first and second potential differences to the MEMS elements in an alternating fashion, The first and second potential differences are applied to the MEMS elements at defined times and for defined time durations that depend on the rate at which image data is written to the array of MEMS. The first and second potential differences are each applied to the MEMS elements for an approximately equal amount of time over a given period of display use. The controller is further configured to write the same frame of data using both potential differences. The apparatus also comprises at least one output port which is configured to communicate, at least in part, the potential difference to the MEMS display element during the first portion of the display write process.

In yet another embodiment, the invention provides an apparatus configured to update a display. The apparatus comprises means for modulating light and means for applying a potential difference to said light modulating means. The means for applying a potential difference to the light modulating means is configured to periodically apply a first potential difference and a second potential difference to the modulating means. The first and second potential differences have opposite polarities and approximately equal magnitudes which are sufficient to actuate the light modulating means. The first potential difference and said second potential difference are respectively applied to the light modulating means at defined times and for defined time durations that depend on the rate at which image data is written to the modulating means, The first and second potential differences are each applied to the light modulating means for an approximately equal amount of time over a given period of display use. The applying means are further configured to write the same frame of data using both potential both the first and second potential differences.

In yet another embodiment, the invention provides a method of operating a MEMS element in an array of MEMS elements forming a display. The method comprises periodically applying a first potential difference to the MEMS element where the first potential difference has a polarity and a magnitude sufficient to actuate the MEMS element. The method further comprises periodically applying a second potential difference to said MEMS element, said second potential difference being of opposite polarity and approximately equal magnitude to said first potential difference. These first and second potential differences are respectively applied to the MEMS element at defined times and for defined time durations that depend on the rate at which image data is written to the array of MEMS elements. The first and second potential differences are each applied to the MEMS element for an approximately equal amount of time over a given period of display use. The method further comprises writing the same frame of data using both potential of said first polarity and potential differences of polarity opposite said first polarity.

In still another embodiment, the invention provides an apparatus configured to display images. The apparatus comprises a plurality of MEMS elements in a display; and a controller configured to actuate all of the MEMS elements in a portion of said display and to write display data to said portion.

In still another embodiment, the invention provides an apparatus for displaying images. The apparatus comprising a plurality of means for modulating light, and means for controlling actuation and writing of all of said plurality of means for modulating light in a portion of the display.

In still another embodiment, the invention provides a method of writing display data to an array of MEMS display elements. The method comprises actuating all MEMS elements in a portion of the array and writing display data to said portion of said array.

In still another embodiment, the invention provides a system configured to write data to an array of MEMS display elements. The system comprises a column driver and a row driver. The row driver and column driver are configured to actuate at least some elements of the array with first and second potential differences, wherein the absolute value of the second potential difference is greater than the absolute value of the first potential difference.

In still another embodiment, the invention provides a system configured to write data to an array of MEMS display elements. The system comprises means for driving a column of said MEMS display elements and means for driving a row of said MEMS display elements. The row and column, driving means are configured to actuate at least some elements of said array with first and second potential differences, wherein the absolute value of the second potential difference is greater than the absolute value of the first potential difference.

In still another embodiment, the invention provides a method of writing display data to an array of MEMS display elements comprising actuating at least some elements of said array with first and second potential differences, wherein the absolute value of the second potential difference is greater than the absolute value of the first potential difference.

### BRIEF DESCRIPTION OF THE DRAWINGS

Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and colunm voltages that may be used to drive an interferometric modulator display.
Figure 5A illustrates one exemplary frame of display data in the 3x3 interferometric modulator display of Figure 2.
Figure 5B illustrates one exemplary timing diagram for row and column signals that may be used to write the frame of Figure 5A.
Figure 6A is a cross section of the device of Figure 1.
Figure 6B is a cross section of an alternative embodiment of an interferometric, modulator.
Figure 6C is a cross section of another alternative embodiment of an interferometric modulator.
Figure 7 is an exemplary timing diagram for row and column signals that may be used in one embodiment of the invention.
Figures 8A and 8B illustrate a sets of row and column voltages that may be used to drive an interferometric modulator display in one embodiment of the invention
Figures 9A and 9B are system block diagrams illustrating an embodiment of a visual display device comprising a plurality of interferometric modulators,

### DETAILED DESCRIPTION OF PREFERRED EMBODIMENTS

The following detailed description is directed to certain specific embodiments of the invention. However, the invention can be embodied in a multitude of different ways. In this description, reference is made to the drawings wherein like parts are designated with like numerals throughout. As will be apparent from the following description, the invention may be implemented in any device that is configured to display an image, whether in motion (e,g., video) or stationary (e.g., still image), and whether textual or pictorial. More particularly, it is contemplated that the invention, may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e,g., display of images on a piece of jewelry). MEMS devices of similar structure to those described herein can also be used in non-display applications such as in electronic switching devices.

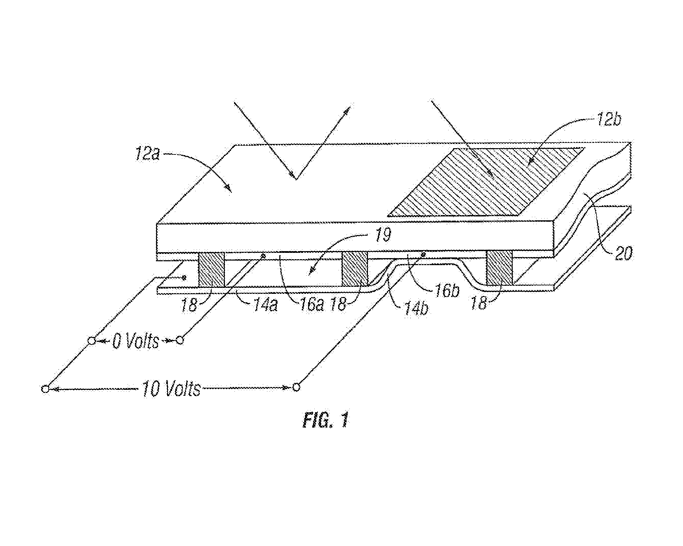

One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure 1 is an isometric view depicting two adjacent pixels in a series of pixels of a visual display, wherein each pixel comprises a MEMS interferometric modulator In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the released state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators 12a and 12b, In the interferometric modulator 12a on the left, a movable and highly reflective layer 14a is illustrated in a released position at a predetermined distance from a fixed partially reflective layer 16a, In the interferometric modulator 12b on the right, the movable highly reflective layer 14b is illustrated in an actuated position adjacent to the fixed partially reflective layer 16b.

The fixed layers 16a, 16b are electrically conductive, partially transparent and partially reflective, and may be fabricated, for example, by depositing one or more layers each of chromium and indium-tin-oxide onto a transparent substrate 20. The layers are patterned into parallel strips, and may from row electrodes in a display device as described further below. The movable layers 14a, 14b may be formed as a series of parallel strips of a deposited metal layer or layers (orthogonal to the row electrodes 16a, 16b) deposited on top of posts 18 and an intervening sacrificial material deposited between the posts 18. When the sacrificial material is etched away, the deformable metal layers are separated from the fixed metal layers by a defined air gap 19. A highly conductive and reflective material such as aluminum may be used for the deformable layers, and these strips may form column electrodes in a display device.

With no applied voltage, the cavity 19 remains between the layers 14a, 16a and the deformable layer is in a mechanically relaxed state as illustrated by the pixel 12a in Figure 1. However, when a potential difference is applied to a selected and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel 12b on the right in Figure 1. The behavior is the same regardless of the polarity of the applied potential difference. In this way, row/column actuation that can control the reflective vs. non-reflective pixel states is analogous in many ways to that used in conventional LCD and other display technologies.

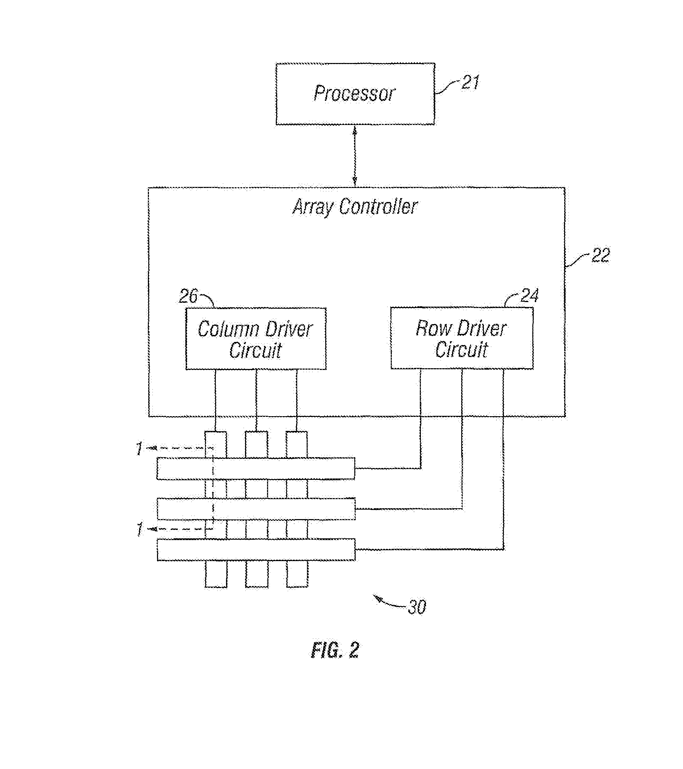

Figures 2 through 5 illustrate one exemplary process and system for using an array of interferometric modulators in a display application. Figure 2 is a system block diagram illustrating one embodiment of an electronic device that may incorporate aspects of the invention. In the exemplary embodiment, the electronic device includes a processor 21 which may be any general purpose single or multi-chip microprocessor such as an ARM, Pentium^{®}, Pentium II^{®}, Pentium III^{®}, Pentium IV^{®}, Pentium^{®} Pro, an 8051, a MIPS^{®}, a Power PC^{®}, an ALPHA^{®}, or any special purpose microprocessor such as a digital signal processor, microcontroller, or a programmable gate array. As is conventional in the art, the processor 21 may be configured to execute one or more software modules. In addition to executing an operating system, the processor may be configured to execute one or more software applications, including a web browser, a telephone application, an email program, or any other software application.

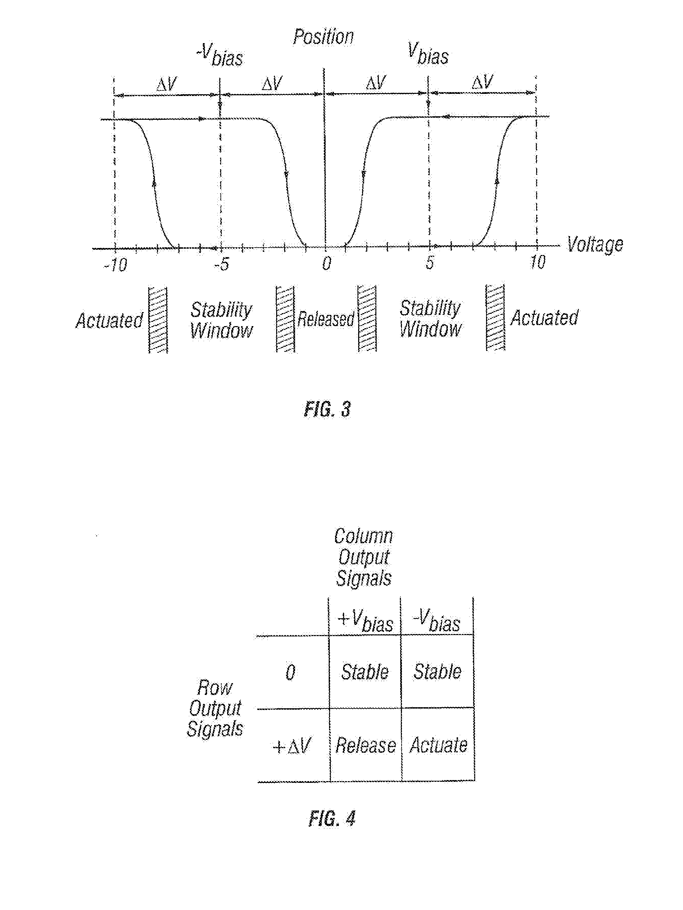

In one embodiment, the processor 21 is also configured to communicate with an array controller 22. In one embodiment, the array controller 22 includes a row driver circuit 24 and a column driver circuit 26 that provide signals to a pixel array 30. The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform, from the released state to the actuated state. However, when the voltage is reduced from that value, the movable layer maintains its state as the voltage drops back below 10 volts. In the exemplary embodiment of Figure 3, the movable layer does not release completely until the voltage drops below 2 volts. There is thus a range of voltage, about 3 to 7 V in the example illustrated in Figure 3, where there exists a window of applied voltage within which the device is stable in either the released or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be released are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or released pre-existing state. Since each pixel of the interferometric modulator, whether in the actuated or released state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

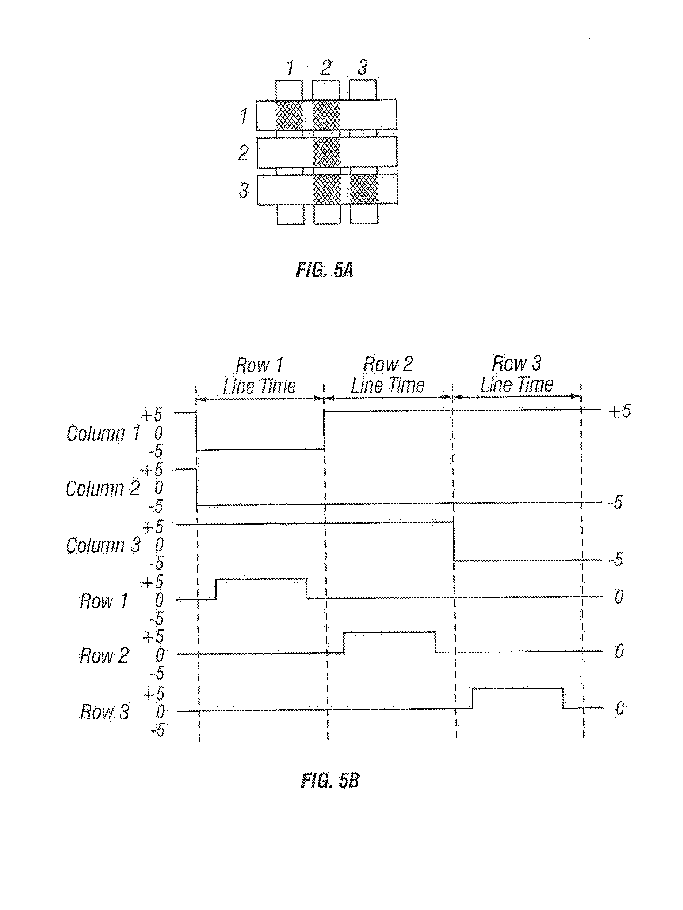

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to ---V_{bias}, and the appropriate row to +ΔV, which may correspond to -5 volts and +5 volts respectively Releasing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or -V_{bias}.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or released states.

In the Figure 5A frame, pixels (1,1), (1,2), (2,2), (3,2) and (3,3) are actuated. To accomplish this, during a "line time" for row 1, columns 1 and 2 are set to -5 volts, and column 3 is set to +5 volts. This does not change the state of any pixels, because all the pixels remain in the 3-7 volt stability window. Row 1 is then strobed with a pulse that goes from 0, up to 5 vols, and back to zero. This actuates the (1,1) and (1,2) pixels and releases the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and release pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention. For example, it will be appreciated that the array elements may be driven with voltages that are shifted from the circuit common voltage of the array driving circuit such that the row might go from 6.2 to 6-2V + V_{bias} and similarly the column would switch from a low voltage e,g. 1V to 1V + 2*V_{bias}. In this embodiment, the release voltage may be slightly different from zero volts. It can be as large as a couple of volts but is typically less than one volt.

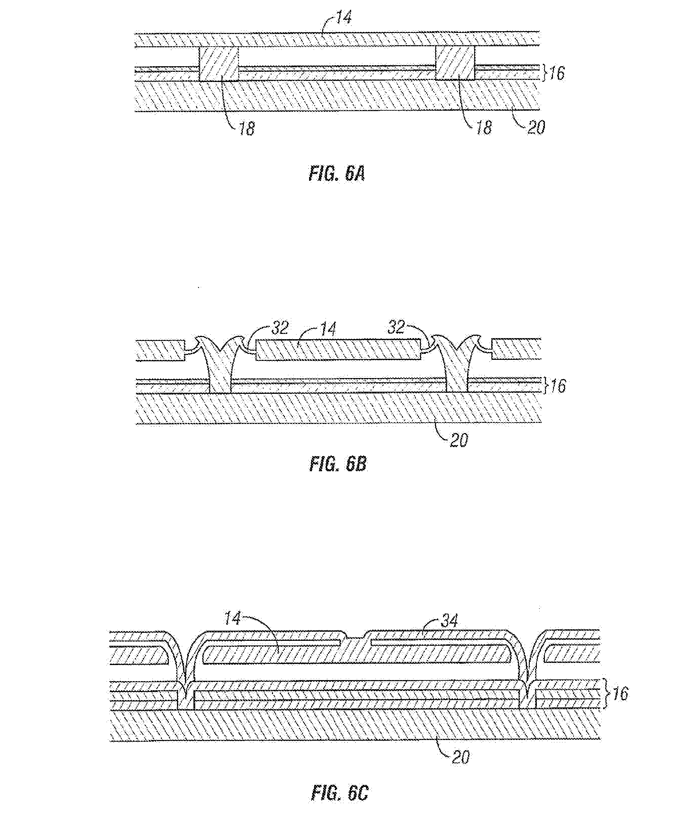

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 1, where a strip of metal material 14 is deposited on orthogonally extending supports 18. In Figure 6B, the moveable reflective material 14 is attached to supports at the corners only, on tethers 32. In Figure 6C, the moveable reflective material 14 is suspended from a deformable layer 34. This embodiment has benefits because the structural design and materials used for the reflective material 14 can optimized with respect to the optical properties, and the structural and materials used for the deformable layer 34 can be optimized with respect to desired mechanical properties. The production of various types of interferometric devices is described in a variety of published documents, including, for example, U.S. Published Application 2004/0051929. A wide variety of well known techniques may be used to produce the above described structures involving a series of material deposition, patterning, and etching steps.

It is one aspect of the above described devices that charge can build on the dielectric between the layers of the device, especially when the devices are actuated and held in the actuated state by an electric field that is always in the same direction. For example, if the moving layer is always at a higher potential relative to the fixed layer when the device is actuated by potentials having a magnitude larger than the outer threshold of stability, a slowly increasing charge buildup on the dielectric between the layers can begin to shift the hysteresis curve for the device. This is undesirable as it causes display performance to change over time, and in different ways for different pixels that are actuated in different ways over time. As can be seen in the example of Figure SB, a given pixel sees a 10 volt difference during actuation, and every time in this example, the row electrode is at a 10 V higher potential than the column electrode. During actuation, the electric field between the plates therefore always points in one direction, from the row electrode toward the column electrode.

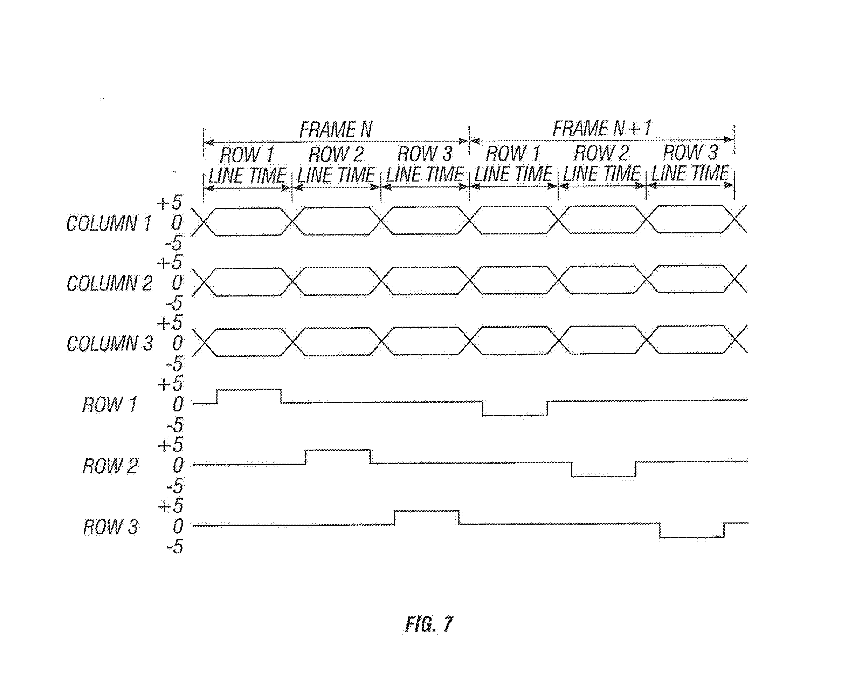

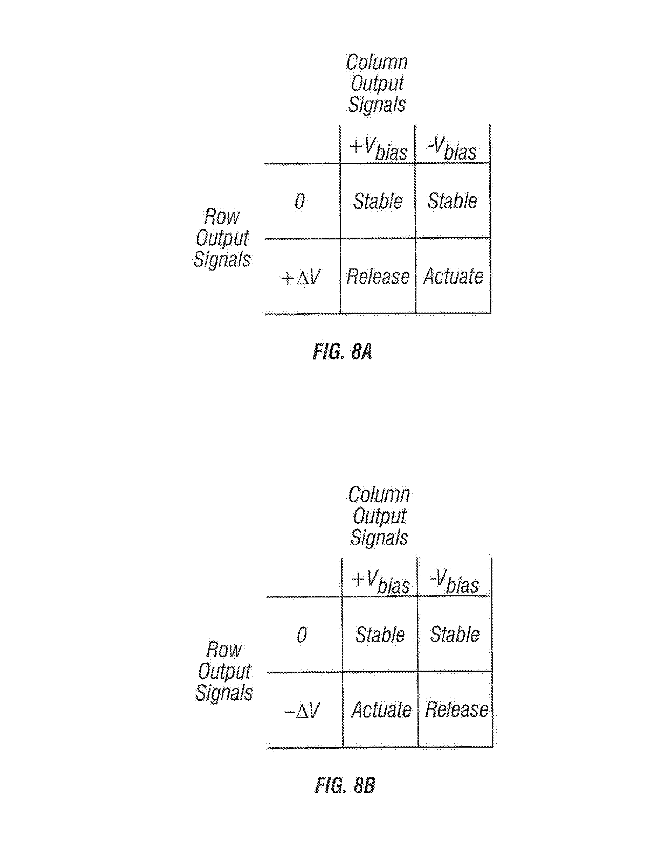

This problem can be reduced by actuating the MEMS display elements with a potential difference of a first polarity during a first portion of the display write process, and actuating the MEMS display elements with a potential difference having a polarity opposite the first polarity during a second portion of the display write process. This basic principle is illustrated in Figures 7, 8A, and 8B.

In Figure 7, two frames of display data are written in sequence, frame N and frame N+1. In this Figure, the data for the columns goes valid for row 1 (i.e., either +5 or -5 depending on the desired state of the pixels in row 1) during the row 1 line time, valid for row 2 during the row 2 line time, and valid for row 3 during the row 3 line time. Frame N is written as shown in Figure 5B, which will be termed positive polarity herein, with the row electrode 10 V above the column electrode during MEMS device actuation. During actuation, the column electrode may be at -5 V, and the scan voltage on the row is +5 V in this example. The actuation and release for Frame N is thus performed according to the table in Figure 8A, which is the same as Figure 4.

Frame N+1 is written in accordance with the table in Figure 8B. For Frame N+1, the scan voltage is -5 V, and the column voltage is set to +5 V to actuate, and -5 V to release. Thus, in Frame N+1, the column voltage is 10 V above the row voltage, termed a negative polarity herein. As the display is continually refreshed, and/or updated, the polarity can be alternated between frames, with Frame N+2 being written in the same manner as Frame N, Frame N+3 written in the same manner as Frame N+1, and so on. In this way, actuation of pixels takes place in both polarities. In embodiments following this principle, potentials of opposite polarities are respectively applied to a given MEMS element at defined times and for defined time durations that depend on the rate at which image data is written to MEMS elements of the array, and the opposite potential differences are each applied an approximately equal amount of time over a given period of display use. This helps reduce charge buildup on the dielectric over time.

A wide variety of modifications of this scheme can be implemented. For example, Frame N and Frame N+1 can comprise different display data. Alternatively, it can be the same display data written twice to the array with opposite polarities. It can also be advantageous to dedicate some frames to setting the state of all or substantially all pixels to a released state, and/or setting the state of all or substantially all the pixels to an actuated state prior to writing desired display data. Setting all the pixels to a common state can be performed in a single row line time by, for example, setting all the columns to +5 V (or -5 V) and scanning all the rows simultaneously with a -5 V scan (or +5 V scan).

In one such embodiment, desired display data is written to the array in one polarity, all the pixels are released, and the same display data is written a second time with the opposite polarity. This is similar to the scheme illustrated in Figure 7, with Frame N the same as Frame N+1, and with an array releasing line time inserted between the frames. In another embodiment, each display update of new display data is preceded by a releasing row line time.

In another embodiment, a row line time is used to actuate all the pixels of the array, a second line time is used to release all the pixels of the array, and then the display data (Frame N for example) is written to the display. In this embodiment, Frame N+1 can be preceded by an array actuation line time and an array release line time of opposite polarities to the ones preceding Frame N, and then Frame N+1can be written. In some embodiments, an actuation line time of one polarity, a a release line time of the same polarity, an actuation line time of opposite polarity, and a release line time of opposite polarity can precede every frame. These embodiments ensure that all or substantially all pixels are actuated at least once for every frame of display data, reducing differential aging effects as well as reducing charge buildup.

In some cases, it may be advantageous to use an extra high actuation voltage during the array actuation line times. For example, during the array actuation line times described above, the row scan voltages can be 7 V or 10 V instead of 5 V. In this embodiment, the highest voltages applied to the pixel occur during these "over-actuation" array actuation times, and not during display data updates. This can also help reduce differential aging effects for different pixels, some of which may change frequently during display updates, whereas others may change very infrequently during display updates, depending on the images being displayed.

It is also possible to perform these polarity reversals and actuation/release protocols on a row by row basis. In these embodiments, each row of a frame may be written more than once during the frame writing process. For example, when writing row 1 of Frame N, the pixels of row I could all be released, and the display data for row I can be written with positive polarity. The pixels of row 1 could be released second time, and the row 1 display data written again with negative polarity. Actuating all the pixels of row 1 as described above for the whole array could also be performed. It will further be appreciated that the releases, actuations, and over-actuations may be performed at a lower frequency than every row write or every frame write during the display updating/refreshing process.

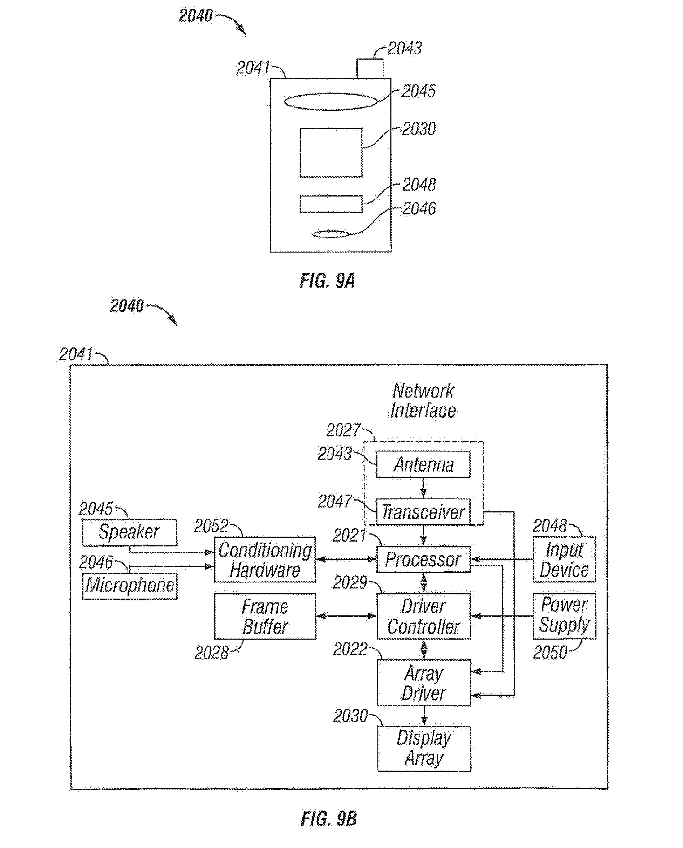

Figures 9A and 9B are system block diagrams illustrating an embodiment of a display device 2040. The display device 2040 can be, for example, a cellular or mobile telephone. However, the same components of display device 2040 or slight variations thereof are also illustrative of various types of display devices such as televisions and portable media players.

The display device 2040 includes a housing 2041, a display 2030, an antenna 2043, a speaker 2045, an input device 2048, and a microphone 2046. The housing 2041 is generally formed from any of a variety of manufacturing processes as are well known to those of skill in the art, including injection molding, and vacuum forming. In addition, the housing 2041 may be made from any of a variety of materials, including but not limited to plastic, metal, glass, rubber, and ceramic, or a combination thereof. In one embodiment the housing 2041 includes removable portions (not shown) that may be interchanged with other removable portions of different color, or containing different logos, pictures, or symbols.

The display 2030 of exemplary display device 2046 may be any of a variety of displays, including a bi-stable display, as described herein. In other embodiments, the display 2030 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 2030 includes an interferometric modulator display, as described herein.

The components of one embodiment of exemplary display device 2040 are schematically illustrated in Figure 9B. The illustrated exemplary display device 2040 includes a housing 2041 and can include additional components at least partially enclosed therein. For example, in one embodiment, the exemplary display device 2040 includes a network interface 2027 that includes an antenna 2043 which is coupled to a transceiver 2047. The transceiver 2047 is connected to the processor 2021, which is connected to conditioning hardware 2052. The conditioning hardware 2052 may be configured to condition a signal (e.g. filter a signal). The conditioning hardware 2052 is connected to a speaker 2045 and a microphone 2046. The processor 2021 it also connected to an input device 2048 and a driver controller 2029. The driver controller 2029 is coupled to a frame buffer 2028 and to the array driver 2022, which in turn is coupled to a display array 2030. A power supply 2050 provides power to all components as required by the particular exemplary display device 2040 design.

The network interface 2027 includes the antenna 2043 and the transceiver 2047 so that the exemplary display device 2040 can communicate with one or more devices over a network. In one embodiment the network interface 2027 may also have some processing capabilities to relieve requirements of the processor 2021. The antenna 2043 is any antenna known to those of skill in the art for transmitting and receiving signals. In one embodiment, the antenna transmits and receives RF signals according to the IEEE 802.11 standard, including lEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 2047 pre-processes the signals received from the antenna 2043 so that they may be received by and further manipulated by the processor 2021. The transceiver 2047 also processes signals received from the processor 2021 so that they may be transmitted from the exemplary display device 2040 via the antenna 2043.

In an alternative embodiment, the transceiver 2047 can be replaced by a receiver. In yet another alternative embodiment, network interface 2027 can be replaced by an image source, which can store or generate image data to be sent to the processor 2021. For example, the image source can be a digital video disc (DVD) or a hard-disc drive that contains image data, or a software module that generates image data.

Processor 2021 generally controls the overall operation of the exemplary display device 2040. The processor 2021 receives data, such as compressed image data from the network interface 2027 or an image source, and processes the data into raw image data or into a format that is readily processed into raw image data, The processor 2021 then sends the processed data to the driver controller 2029 or to frame buffer 2028 for storage. Raw data typically refers to the information that identifies the image characteristics at each location within an image. For example, such image characteristics can include color, saturation, and gray-scale level.

In one embodiment, the processor 2021 includes a microcontroller, CPU, or logic unit to control operation of the exemplary display device 2040. Conditioning hardware 2052 generally includes amplifiers and filters for transmitting signals to the speaker 2045, and for receiving signals from the microphone 2046. Conditioning hardware 2052 may be discrete components within the exemplary display device 2040, or may be incorporated within the processor 2021 or other components.

The driver controller 2029 takes the raw image data generated by the processor 2021 either directly from the processor 2021 or from the frame buffer 2028 and reformats the raw image data appropriately for high speed transmission to the array driver 2022. Specifically, the driver controller 2029 reformats the raw image data into a data flow having a raster-like format, such that it has a time order suitable for scanning across the display array 2030. Then the driver controller 2029 sends the formatted information to the array driver 2022. Although a driver controller 2029, such as a LCD controller, is often associated with the system processor 2021 as a stand-alone Integrated Circuit (IC), such controllers may be implemented in many ways. They may be embedded in the processor 2021 as hardware, embedded in the processor 2021 as software, or fully integrated in hardware with the array driver 2022.

Typically, the array driver 2022 receives the formatted information from the driver controller 2029 and reformats the video data into a parallel set of waveforms that are applied many times per second to the hundreds and sometimes thousands of leads coming from the display's x-y matrix of pixels.

In one embodiment, the driver controller 2029, array driver 2022, and display array 2030 are appropriate for any of the types of displays described herein. For example, in one embodiment, driver controller 2029 is a conventional display controller or a bi-stable display controller (e.g., an interferometric modulator controller), In another embodiment, array driver 2022 is a conventional driver or a bi-stable display driver (e.g., an interferometric modulator display). In one embodiment, a driver controller 2029 is integrated with the array driver 2022. Such an embodiment is common in highly integrated systems such as cellular phones, watches, and other small area displays. In yet another embodiment, display array 2030 is a typical display array or a bi-stable display array (e.g., a display including an array of interfero-metric modulators).

The input device 2048 allows a user to control the operation of the exemplary display device 2040. In one embodiment, input device 2048 includes a keypad, such as a QWERTY keyboard or a telephone keypad, a button, a switch, a touch-sensitive screen, a pressure- or heat-sensitive membrane. In one embodiment, the microphone 2046 is an input device for the exemplary display device 2040. When the microphone 2046 is used to input, data to the device, voice commands may be provided by a user for controlling operations of the exemplary display device 2040.

Power supply 2050 can include a variety of energy storage devices as are well known in the art. For example, in one embodiment, power supply 2050 is a rechargeable battery, such as a nickel-cadmium battery or a lithium ion battery. In another embodiment, power supply 2050 is a renewable energy source, a capacitor, or a solar cell, including a plastic solar cell, and solar-cell paint. In another embodiment, power supply 2050 is configured to receive power from a wall outlet.

In some implementations control programmability resides, as described above, in a driver controller which can be located in several places in the electronic display system. In some cases control programmability resides in the array driver 2022. Those of skill in the art will recognize that the above-described optimization may be implemented in any number of hardware and/or software components and in various configurations.

While the above detailed description has shown, described, and pointed out novel features of the invention as applied to various embodiments, it will be understood that various omissions, substitutions, and changes in the form and details of the device or process illustrated may be made by those skilled in the art, without departing from the spirit of the invention. As one example, it will be appreciated that the test voltage driver circuitry could be separate from the array driver circuitry used to create the display. As with current sensors, separate voltage sensors could be dedicated to separate row electrodes. The scope of the invention is indicated by the: appended, claims rather than the foregoing description. All changes which come within the meaning and range of equivalency of the claims are to be embraced within their scope.

### ADDITIONAL ASPECTS

Additional aspects of the invention are set out in the following clauses.
1. An apparatus configured to drive a MEMS display element, the apparatus comprising:
   a controller configured to control a driver circuit that actuates a MEMS display element with a potential difference of a first polarity during a first portion of a display write process, the controller being configured to cause the driver circuit to release said MEMS display element after said actuation and then to actuate said MEMS display element with a potential difference of a polarity opposite to said first polarity during a second portion of said display write process; and
   at least one output port configured to communicate at least in part the potential difference to the MEMS display element during the first portion of the display write process.
2. The apparatus of Clause 1, wherein said at least one output port comprises at least one chip pin.
3. The apparatus of Clause wherein said at least one output port comprises at least one conductive wire.
4. The apparatus of Clause 1, wherein said at least one output port comprises at least one interface to said driver circuit.
5. The apparatus of Clause 1, wherein said at least one output port comprises at least one row output port and at least one column output port.
6. The apparatus of Clause 1, wherein said first portion of said display write process comprises writing a first frame of display data to said MEMS display element and wherein, said second portion of said display write process comprises writing a second frame of display data to said MEMS display element.
7. The apparatus of Clause 6, wherein one or more other frames of display data are written to said MEMS display element between said first frame and said second frame.
8. The apparatus of Clause 1, wherein said controller is further configured to actuate said MEMS display element with a potential difference of said first polarity during a third portion of said display write process.
9. The apparatus of Clause 1, wherein said controller is further configured to alternately apply potential differences of opposite polarity to the MEMS display elements during alternating portions of said display write process.
10. The apparatus of Clause 9, wherein alternating portions of said display write process comprise writing alternating frames of display data to the MEMS display elements.
11. The apparatus of Clause 10, wherein said alternating portions of said display write process comprise writing alternating rows of display data to an array of MEMS display elements.
12. The apparatus of Clause 1, wherein said controller is configured to:
   write a first frame of display data to an array of MEMS display elements with a potential difference of said first polarity so as to actuate said MEMS display elements;
   place substantially all MEMS elements in said array in a released state; and
   write a second frame of display data to said array with a potential difference of polarity opposite said first polarity so as to actuate said MEMS display elements.
13. The apparatus of Clause12, wherein said first frame of display data and said second frame display data are the same.
14. The apparatus of Clause 1, further comprising:
   a processor that is in electrical communication with said MEMS display element, said processor being configured to process image data; and
   a memory device in electrical communication with said processor.
15. The apparatus of Clause 14, wherein the processor is configured to send at least a portion of said image data to said controller.
16. The apparatus of Clause 14, further comprising an image source module configured to send said image data to said processor.
17. The apparatus of Clause 16, wherein said image source module comprises at least one of a receiver, transceiver, and transmitter.
18. The apparatus of Clause 14, further comprising an input device configured to receive input data and to communicate said input data to said processor.
19. The apparatus of Clause 1, wherein the controller is configured to:
   place: substantially all MEMS elements in a row of an array of MEMS display elements into a released state;
   write a first set of display data to a row with a potential difference of said first polarity so as to actuate said MEMS display element;
   place substantially all MEMS elements in said row in a released state; and
   write a second set of display data to said row with a potential difference of a polarity opposite said first polarity so as to actuate said MEMS display element.
20. The apparatus of Clause 19, wherein said first set of display data and said second set of display data comprise identical data.
21. An apparatus configured to drive a set of MEMS display elements, the apparatus comprising:
   means for controlling actuation of said MEMS display elements with a potential difference of a first polarity during a first portion of a display write process and for causing release of said MEMS display elements and then controlling actuation said MEMS display elements with a potential difference having a polarity opposite said first polarity during a second portion of said display write process: and
   means for communicating at least in part the potential difference, to said MEMS display element during the first portion of the display write process.
22. The apparatus of Clause 21, wherein said means for controlling actuation of said MEMS display elements comprises a controller.
23. The apparatus of Clause 22, wherein said means for causing release of said MEMS display elements comprises a controller.
24. The apparatus of Clause 21, wherein said means for controlling actuation of said MEMS display elements comprises a processor.
25. The apparatus of Clause 21, wherein said means for controlling actuation of said MEMS display elements with a potential difference of a first polarity comprises writing a first frame of display data to said set of MEMS display elements and wherein said second portion of said display write process comprises writing a second frame of display data to said set of MEMS display elements.
26. The apparatus of Clause 25, wherein one or more other frames of display data are written to said set between said first frame and said second frame.
27. The apparatus of Clause 21, wherein said apparatus is further configured to control actuation of said MEMS display element with a potential difference of said first polarity during a third portion of said display write process.
28. The apparatus of Clause 21, wherein said apparatus is further configured to alternately apply potential differences of opposite polarity to display elements of said sel during alternating portions of said display write process.
29. The apparatus of Clause 28, wherein alternating portions of said display write process comprise writing alternating frames of display data to said set of MEMS display elements.
30. The apparatus of Clause 29, wherein said alternating portions of said display write process comprise writing alternating rows of display data to said set of MEMS display elements.
31. The apparatus of Clause 21, wherein said apparatus is further configured to:
   write a first frame of display data to said set of MEMS display elements with a potential difference of said first polarity by controlling actuation of said MEMS display element; place substantially all MEMS elements in said set in released state; and
   write a second frame of display data to said set with a potential difference of polarity opposite said first polarity by controlling actuation of said MEMS display element.
32. The apparatus of Clause 31, wherein said first frame of display data and said second frame of display data are the same.
33. The apparatus of Clause 21, wherein said apparatus is configured to:
   place substantially all MEMS elements in a row of said set into a released state;
   write a fïrst set of display data to said row of said set with a potential difference of said first polarity by controlling actuation of said MEMS display element;
   place substantially all MEMS elements in said of said set in a released state; and
   write a second set of display data to said row of said set with a potential difference of polarity opposite said first polarity by controlling actuation of said MEMS display element.
34. The apparatus of Clause 33, wherein said apparatus comprises a controller.
35. The apparatus of Clause 33, wherein said first set of display data and said second set of display data comprise identical data.
36. The apparatus of Clause 21 wherein said means for communicating at least in part the potential difference to said MEMS display element comprises at least one output port in communication with a controller.
37. The apparatus of Clause 21, wherein said means for communicating at least in part the potential difference to said MEMS display element comprises at least one chip pin.
38. The apparatus of Clause 21, wherein said means for communicating at least in part the potential difference to said MEMS display element comprises at least one conductive wire.
39. The apparatus of Clause 21, wherein said means for communicating at least in part the potential difference to said MEMS display element comprises at least one interface to a driver circuit that actuates a MEMS display element.
40. A method of actuating a set of MEMS display elements, said MEMS display elements comprising a portion of an array of MEMS display elements, said method comprising:
   actuating said MEMS display elements with a potential difference of a first polarity during a first portion of a display write process;
   releasing said MEMS display elements; and
   actuating said MEMS display elements with a potential difference having a polarity opposite said first polarity during a second portion of said display write process.
41. The method of Clause 40, wherein said first portion of said display write process comprises writing a first frame of display data to said array of MEMS display elements and wherein said second portion of said display write process comprises writing a second frame of display data to said array of MEMS display elements.
42. The method of Clause 41, wherein one or more other frames of display data are written to said array between said first frame and said second frame.
43. The method of Clause 40, further comprising actuating said MEMS display element with a potential difference of said first polarity during a third portion of said display write process.
44. The method of Clause 40, further alternately applying potential differences of opposite polarity to display elements of said array during alternating portions of said display write process.
45. The method of Clause 44, wherein said alternating portions of said display write process comprise writing alternating frames of display data to said array of MEMS display elements.
46. The method of Clause 45, wherein said alternating portions of said display write process comprise writing alternating rows of display data to said array of MEMS display elements.
47. The method of Clause 40, further comprising:
   placing substantially all MEMS elements in a row of said array into a released state:
      writing a first set of display data to said row of said array with a potential difference of said first polarity so as to actuate said MEMS display element;
      placing substantially all MEMS elements in said row of said array in a released state; and
      writing a second set of display data to said row of said array with a potential difference of a polarity opposite said first polarity so as to actuate said MEMS display element.
48. The method of Clause 47, wherein said first set of display data and said second set of display data comprise identical data.
49. The method of Clause 40, further comprising:
   writing a first frame of display data to said array with a potential difference of said first polarity so as to actuate said MEMS display element;
   placing substantially all MEMS elements in said array in a released state; and
   writing a second frame of display data to said array with a potential difference of a polarity opposite said first polarity so as to actuate said MEMS display element.
50. The method of Clause 49, wherein said first frame of display data and said second frame of display data are the same.
51. An apparatus configured to operate a MEMS element in an array of MEMS elements forming a display, said apparatus comprising:
   a controller configured to control a driver circuit that periodically applies a first potential difference to said MEMS element, said first potential difference having a magnitude sufficient to actuate said MEMS element, and having a polarity, the controller being configured to periodically apply a second potential difference to said MEMS element, said second potential difference being of approximately equal magnitude and opposite polarity as said first potential difference, wherein said first potential difference and said second potential difference are respectively applied to said MEMS element at defined times and for defined time durations that depend on a rate at which image data is written to MEMS elements of said array, and wherein said first and second potential differences are each applied to said MEMS element as approximately equal amount of time over a given period at display use, the controller further configured to write the same frame of data using both potential differences of said first polarity and potential differences opposite said first polarity; and
   at least one output port configured to communicate at least in part the potential difference to the MEMS display element during the first portion of the display write process.
52. The apparatus of Clause 51, further comprising:
   a processor that is in electrical communication with said MEMS element, said processor being configured to process image data; and
   a memory device in electrical communication with said processor.
53. The apparatus of Clause 52, further comprising a processor configured send at least a portion of said image data to a controller in communication with said MEMS display elements.
54. The apparatus of Clause 52, further comprising an image source module configured to send said image data to said processor.
55. The apparatus of Clause 54, wherein said image source module comprises at least one of a receiver, transceiver, and transmitter.
56. The apparatus of Clause 52, further comprising an input device configured to receive input data and to communicate said input data to said processor.
57. The apparatus of Clause 51, wherein said at least one output port configured to communicate at least in part the potential difference to the MEMS display element comprises at least one chip pin.
58. The apparatus of Clause 51, wherein said at least one output port configured to communicate at least in part the potential difference to the MEMS display element comprises at least one conductive wire.
59. The apparatus of Clause 51, wherein said at least one output port configured to communicate at least in part the potential difference to the MEMS display element comprises at least one interface to said driver circuit.
60. The apparatus of Clause 51, wherein said at least one output port configured to communicate at least in part the potential difference to the MEMS display element comprises at least one row output port and at least one column output port.
61. An apparatus for updating a display, the apparatus comprising:
   means for modulating light; and
   means for applying a potential difference to said modulating means, said applying means configured to periodically apply a first potential difference and a second potential difference to said modulating means, said first and second potential differences having opposite polarity and an approximately equal magnitude sufficient to actuate said modulating means, wherein said first potential difference and said second potential difference are respectively applied to said modulating means at defined times and for defined time durations that depend on a rate at which image data is written to modulating means, and wherein said first and second potential differences are each applied to said modulating means an approximately equal amount of time over a given period of display use and wherein said applying means is further configured to write the same frame of data using both potential differences of said first polarity and potential differences of polarity opposite said first polarity.
62. The apparatus of Clause 61, wherein said applying means comprise a driver circuit.
63. The apparatus of Clause 61, wherein said applying means comprises at least one output port.
64. The apparatus of Clause 63, wherein said output port comprises at least one chip pin.
65. The apparatus of Clause 63, wherein said output port comprises at least one conductive wire.
66. The apparatus of Clause 63, wherein said output port comprises at least one interface to a driver circuit.
67. The apparatus of Clauses 61, wherein the means for modulating light comprises an interferometric modulating MEMS device.
68. A method of operating a MEMS element in an array of MEMS elements forming a display, said method comprising:
   periodically applying a first potential difference to said MEMS element, said first potential difference having a magnitude sufficient to actuate said MEMS element, and having a polarity: and
   periodically applying a second potential difference to said MEMS element, said second potential difference being of approximately equal magnitude and polarity opposite the polarity of said first potential difference;
   wherein said first potential difference and said second potential difference are respectively applied to said MEMS element at defined times and for defined time durations that depend on a rate at which image data is written to MEMS elements of said array, and wherein said first and second potential differences are each applied to said MEMS element an approximately equal amount of time over a given period of display use;
   wherein said method comprises writing the same frame of data using both potential differences of said first polarity and potential differences of polarity opposite said first polarity.
69. An apparatus for displaying images, the apparatus comprising:
   a plurality of MEMS elements in a display; and
   a controller configured to actuate all of the MEMS elements in a portion of said display and to write display data to said portion.
70. The apparatus of Clause 69, wherein at least one of said MEMS elements comprises an interferometric modulator.
71. The apparatus of Clause 69, further comprising:
   a processor that is in electrical communication with at least one of said plurality of MEMS elements, said propessor being configured to process image data; and
   a memory device in electrical communication with said processor.
72. The apparatus of Clause 71, further comprising an image source module configured to send said image data to said processor.
73. The apparatus of Clause 72, wherein said image source module comprises at least one of a receiver, transceiver, and transmitter.
74. The apparatus of Clause 71, further comprising an input device configured to receive input data and to communicate said input data to said processor.
75. An apparatus for displaying images, the apparatus comprising:
   a plurality of means for modulating light; and
   means for controlling actuation of all of said plurality of means for modulating light and for writing display data in a portion of a display.
76. The apparatus of Clause 75. wherein at least one of said plurality of means for modulating light comprises an interferometric modulating MEMS device.
77. The apparatus of Clause 75, wherein said controlling means comprises a controller.
78. The apparatus of Clause 75, said controlling means further comprises at least one output port in communication with said controller configured to actuate said MEMS display element.
79. The apparatus of Clause 78, wherein said at least one output port comprises at least, one chip pin.
80. The apparatus of Clause 78, wherein said at least one output port comprises at least one conductive wire.
81. The apparatus of Clause 78, wherein said at least one output port comprises at least one interface to a driver circuit configured to actuate said MEMS display element.
82. The apparatus of Clause 75, wherein said portion comprises a row of MEMS display elements.
83. The apparatus of Clause 75, wherein said portion comprises an entire array of MEMS display elements.
84. The apparatus of Clause 75, wherein said controlling means is further configured to release all modulating means in said portion of said array prior to writing display data to said portion
85. A method of writing display data to an array of MEMS display elements, comprising:
   actuating all MEMS elements in a portion of said array; and
   writing display data to said portion of said array.
86. The method of Clause 85, wherein said portion of said array comprises a row of MEMS elements of said array.
87. The method of Clause 85, wherein said portion comprise an entire array.
88. The method of Clause 85, further comprising releasing all MEMS elements in said portion of said array prior to writing display data to said portion of said array.
89. A system configured to write data to an array of MEMS display elements, said system comprising:
   a column driver;
   a row driver, and
   wherein said row driver and column driver are configured to actuate at least some elements of said array with first and second potential differences, wherein the absolute value of the second potential difference is greater than the absolute value of the first potential difference.
90. The system of Clause 89, further comprising:
   a processor that is in electrical communication with said array of MEMS display elements, said processor being configured to process image data; and
   a memory device in electrical communication with said processor.
91. The system of Clause 90, further comprising a controller configured to send at least a portion of said image data to at least one of said row driver and column driver.
92. The system of Clause 90, further comprising an image source module configured to send said image data to said processor.
93. The system of Clause 92, wherein said image source module comprises at least one of a receiver, transceiver, and transmitter.
94. The system of Clause 92, further comprising an input device configured to receive input data and to communicate said input data to said processor.
95. A system configured to write data to an array of MEMS display elements, said system comprising:
   means for driving a column of said MEMS display elements; and
   means for driving a row of said MEMS display elements;
   wherein said row and column driving means are configured to actuate at least some elements of said array with first and second potential differences, wherein the absolute value of the second potential difference is greater than the absolute value of the first potential difference.
96. The system of Clause 95, wherein said column driving means comprise a column driver circuit.
97. The system of Clause 95, wherein said row driving means comprise a driver circuit.
98. A method of writing display data to an array of MEMS display elements comprising actuating at least some elements of said array with first and second potential differences, wherein the absolute value of the second potential difference is greater than the absolute value of the first potential difference.

## Claims

1. An apparatus for updating a display (2030), the apparatus comprising:
means (12a, 12b) for modulating light; and
means for applying a potential difference to said light modulating means, said applying means configured to periodically apply a first potential difference and a second potential difference to said light modulating means, said first and second potential differences having opposite polarity and an approximately equal magnitude sufficient to actuate said light modulating means, wherein said first potential difference and said second potential difference are respectively applied to said light modulating means at defined times and for defined time durations that depend on a rate at which image data is written to the light modulating means, and wherein said first and second potential differences are each applied to said light modulating means an approximately equal amount of time over a given period of display use and wherein said applying means is further configured to write the same frame of data using both potential differences of said first polarity and potential differences of polarity opposite said first polarity.

2. The apparatus of Claim 1, wherein said applying means comprises a driver circuit (2022).

3. The apparatus of Claim 1, wherein said applying means comprises at least one output port.

4. The apparatus of Claims 1, wherein the light modulating means comprises an interferometric modulating device (12a, 12b).

5. The apparatus of Claim 1, further comprising:
a processor (2021) that is in electrical communication with the light modulating means, said processor (2021) being configured to process image data; and
a memory device (2028) in electrical communication with said processor (2021).

6. The apparatus of Claim 1, further comprising a processor (2021) configured to send at least a portion of said image data to said applying means.

7. The apparatus of Claim 6, further comprising an image source module configured to send said image data to said processor (2021).

8. The apparatus of Claim 7, wherein said image source module comprises at least one of a receiver, transceiver (2047), and transmitter.

9. The apparatus of Claim 6, further comprising an input device (2048) configured to receive input data and to communicate said input data to said processor (2021).

10. A method of operating an element (12a, 12b) in an array (30) of elements (12a, 12b) forming a display (2030), said method comprising:
periodically applying a first potential difference to said element (12a, 12b), said first potential difference having a magnitude sufficient to actuate said element (12a, 12b), and having a polarity; and
periodically applying a second potential difference to said element (12a, 12b), said second potential difference being of approximately equal magnitude and polarity opposite the polarity of said first potential difference,
wherein said first potential difference and said second potential difference are respectively applied to said element (12a, 12b) at defined times and for defined time durations that depend on a rate at which image data is written to elements of said array (2030), and wherein said first and second potential differences are each applied to said element (12a, 12b) an approximately equal amount of time over a given period of display use, and
wherein said method comprises writing the same frame of data using both potential differences of said first polarity and potential differences of polarity opposite said first polarity.

11. The method of Claim 10, further comprising alternately applying potential differences of opposite polarity to display elements (12a, 12b) of said array during alternating frames.

12. The method of Claim 10, further comprising alternately applying potential differences of opposite polarity to display elements (12a, 12b) of alternating rows of said array.

13. A computer readable storage medium having stored thereon instructions that when executed cause a logic circuit to perform a method of operating a element in an array of elements forming a display, said method comprising:
periodically applying a first potential difference to said element, said first potential difference having a magnitude sufficient to actuate said element, and having a polarity; and
periodically applying a second potential difference to said element, said second potential difference being of approximately equal magnitude and polarity opposite the polarity of said first potential difference;
wherein said first potential difference and said second potential difference are respectively applied to said element at defined times and for defined time durations that depend on a rate at which image data is written to elements of said array, and wherein said first and second potential differences are each applied to said element an approximately equal amount of time over a given period of display use, and
wherein said method comprises writing the same frame of data using both potential differences of said first polarity and potential differences of polarity opposite said first polarity.

14. The computer readable storage medium of Claim 13, wherein the method further comprises alternately applying potential differences of opposite polarity to display elements of said array during alternating frames.

15. The computer readable storage medium of Claim 13, wherein the method further comprises alternately applying potential differences of opposite polarity to display elements of alternating rows of said array.
